# EUROPEAN PATENT SPECIFICATION

(11) **EP 0 185 941 B1**
(45) Date of publication and mention of the grant of the patent: **10.04.1996**
(21) Application number: 85114866.8
(22) Date of filing: 23.11.1985
(51) Int. Cl.: H01L 51/00, H01M 4/60, H01L 49/00, H01L 27/04, G01N 27/04

(54) **Polymer-based microelectronic pH-sensor**
Mikroelektronischer pH-Sensor auf Polymer-Basis
Detecteur microélectronique de pH à base de polymère

(30) Priority: 23.11.1984 US 674410; 19.11.1985 US 798263
(43) Date of publication of application: 02.07.1986
(73) Proprietor: MASSACHUSETTS INSTITUTE OF TECHNOLOGY, Cambridge, MA 02139 (US)
(72) Inventor: Wrighton, Mark S., Winchester, MA 01890 (US); White, Henry S. Jr., Minneapolis, MN 55415 (US); Thackeray, James W., Cambridge, MA 02139 (US)
(74) Representative: Bassett, Richard Simon

(56) References cited:
- EP-A- 0 096 095
- EP-A- 0 105 768
- EP-A- 0 111 237
- EP-A- 0 145 337
- WO-A-83/02368
- GB-A- 2 021 277
- US-A- 3 902 485
- US-A- 4 472 488
- US-A- 4 473 695
- J. Amer. Chem. Soc., Vol. 106, No. 18, pages 5375-5377, Sept 5th, 1984.
- JOURNAL OF THE ELECTROCHEMICAL SOCIETY, vol. 131, no. 1, January 1984, pages 833-839, Hamshire, US; P.G. PICKUP et al.: "Redox Conduction: Its Use in Electronic Devices"
- JOURNAL OF THE CHEMICAL SOCIETY, CHEMICAL COMMUNICATIONS, 1980, pages 397-398, Herts, GB; F. Diaz et al.: "A polymer electrode with variable conductivity: polypyrrole"
- IBM JOURNAL OF RESEARCH & DEVELOPMENT, vol. 25, no. 1, January 1981, pages 42-60, New York, US; A. Diaz et al.: "(Pt) Polypyrroke: A New Organic Electrode Material"
- JOURNAL OF THE CHEMICAL SOCIETY, CHEMICAL COMMUNICATIONS, 1983, pages 382-383, Herts, GB; K. KANETO et al.: "Electrochemical preparation of a metallic polythiophene film"
- SCIENTIFIC AMERICAN, vol. 253, no. 3, September 1985, page 58, New York, US; Section entitled "Organic Transistors"
- JAPANESE JOURNAL OF APPLIED PHYSICS, vol. 22, part 2, no. 7, July 1983, Tokyo, JP; K. KANETO et al.: "Characteristics of Electro-Optic Device Using Conducting Polymers, Polythiophene and Polypyrrole Films"
- JOURNAL OF THE ELECTROCHEMICAL SOCIETY, vol. 124, no. 1, January 1982, pages 762-767, Hampshire, US; K. ITAYA et al.: "Polymer Modified Electrodes"
- JAPANESE JOURNAL OF APPLIED PHYSICS, vol. 22, part 2, no. 9, September 1983, pages L567-L568; Tokyo, JP; K. KANETO et al.: "Characteristics of A Polythiophene Battery"
- JOURNAL OF THE AMERICAN CHEMICAL SOCIETY, vol. 106, no. 24, 28th November 1984, pages 7389-7396, Gaoton, PA, US; G. KITTLESEN et al.: "Chemical Derivatization of Microelectrode Arrays by Oxidation of Pyrrole and N-Methylpyrrole: Fabrication of Molecule-Based Electronic Devices"
- MOLECULAR CRYSTALS AND LIQUID CRYSTALS, vol. 121, 1985, pages 181-186, London, GB; E. GENIES et al.: "Electrochemical Study of Polyaniline in Aqueous and Organic Medium. Redox and Kinetic Properties"

## Description

### Background of the Invention

The U.S. government has rights in this invention by virtue of Contract No. N0014-75-C-0880, Contract No. NOOO14-82-K-0737, Contract No. N0014-84-K-0553 and Contract No. N00014-84-K-0291 from the Office of Naval Research.

This device is generally in the field of microelectrochemical devices and more particularly in the area of electroactive polymer-based devices.

Presently available solid state microelectronic devices consist of microcircuits with discrete circuit elements such as monolithic integrated circuits, transistors, diodes, resistors, capacitors, transformers, and conductors mounted on an insulating substrate. Thin film hybrid microcircuits are formed by vapor deposition of conductors, such as copper and gold, and resistors, such as tantalum, nichrome, and tin oxide, onto a passive or insulating substrate such as silicon dioxide. An exact conductor pattern is obtained by masking or photolithographic etching. The tie circuit is subsequently encased with an epoxy dip to protect against moisture and contamination.

Modern integrated circuit devices, even highly miniaturized very large scale integrated devices (VLSI), are response only to electrical signals. There is now considerable interest in interfacing microelectronic devices with chemical and biological systems and it is therefore highly desirable to provide a microelectronic device that is responsive to such chemical or biological inputs. Typical applications for these devices include sensing of changes in pH and molar concentrations of chemical compounds, oxygen, hydrogen, and enzyme substrate concentrations.

Applicant is not aware of any apparatus or system which allows a direct interface between a microelectronic device sensitive to chemical inputs and a microminiature electrical circuit. Devices have been made on a larger scale which are sensitive to chemical input. These devices include such well known apparatus as pH sensors.

Recently, a polymeric semiconductor field effect transistor has been disclosed in a Japanese patent, 58-114465. As described in this patent, polymers such as trans-polyacetylene, cis-polyacetylene, polypyrrole, and polyvinyl phenylene have been used as inexpensive substitutes for single crystal silicon or germanium in making a semiconductor field effect transistor. There is no recognition of the unique properties of these polymers in this patent and, in fact, the polymers are treated as semiconducting material even though the properties of the polymers are distinctly different from that of silicon or germanium. The polymers are used as substitutes for semiconducting materials sensitive to electrical signals for uses such as in memory storage. Disadvantages to the FET as disclosed are that it is unstable and has a short useful life.

White et *al* (1984 *J. Am. Chem. Soc.* **106(18)**, 5375-5377) disclosed a transistor-like microscopic arrangement of polypyrrole-coated gold electrodes but there was no disclosure of other electroactive polymers, nor of other uses, and indeed the device was said to have "no immediate practical application".

EP-A-140 322 disclosed macroscopic sensors employing an electroactive polymer and a catalyst.

EP-A-105 768 discloses macroscopic energy storage devices in which an anode and a cathode are coated with electronically conductive organic polymers.

### Summary of Invention

The present invention provides a microelectronic pH sensor device comprising a first and a second electrically conductive electrode on an insulating substrate each overlaid respectively with a first and a second electroactive polymer which completely covers those portions of the respective electrodes which do not abut the substrate, the first and second electroactive polymers being separate from one another but connected together by a third electroactive polymer, wherein the redox potential of the third electroactive polymer is selected to be higher than that of the first electroactive polymer when in contact with a solution of high pH, and between that of the first electroactive polymer and the second electroactive polymer when in contact with a solution of low pH.

### Objects of Preferred Embodiments

It is an object of the present invention to provide a process for producing microelectronic devices responsive to chemical input which can be incorporated into microelectronic systems which are responsive to electrical input.

A further object of the invention is to provide diodes, transistors, sensors, surface energy storage elements, and light-emitting microelectrode devices which can be conbtrolled by molecular-level changes in electroactive polymer components.

It is a still further object of the present invention to provide redox polymer-based microelectronic devices which rapidly and reproducibly amplify very small electrical or chemical signals.

It is another object of the present invention to provide polymer-based microelectronic devices with increased durability in an aqueous solution which are sensitive sensors for pH.

It is another object of the present invention to provide redox polymer-based electronic devices which exhibit "metallic behavior" or a linear relationship between change and potential over a wide range of pH and applied voltage.

In one embodiment, an analogue of a solid state transistor, wherein a transistor is defined as a material whose resistance can be adjusted by an electrical signal, is formed from an array of gold microelectrodes derivatized with a redox polymer. When the polymer is oxidized, it conducts an electrical current between the microelectrodes. As in a solid state transistor, the current between the two outer microelectrodes of the array can be varied as a function of the potential of the polymer electrically connecting the electrodes in a manner analogous to the "channel" of a transistor. As the potential is altered, the oxidation or reduction of the polymer can be effected. This device amplifies the very small signal needed to turn the polymer from its reduced and insulating state to its oxidized and conducting state. Further variations are possible using additional polymers with different redox potentials.

One variation of this transistor-like device is a polymer-based microelectrochemical sensor which is durable in an aqueous electrolyte over a wide pH range. The polymer is grown by the oxidation of thiophene or a thiophene derivative such as 3-methylthiophene and deposited on closely spaced gold or platinum microelectrodes. For example, conductivity of poly-3-methylthiophene changes more than 10⁸ depending on the potential, providing power amplification of a factor of about 1000 at frequencies of 10 Hz. The poly-3-methylthiophene device responds to less than 10⁻¹⁶ moles of oxidant.

### Brief Description of the Drawings

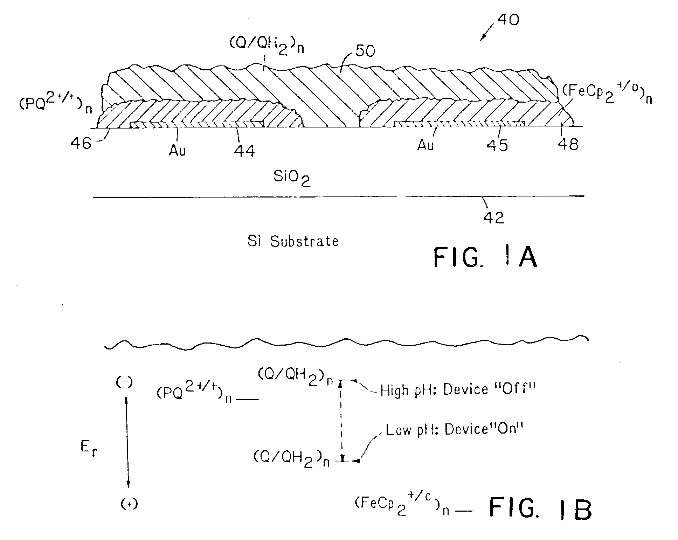

Fig. 1 is a cross-sectional view of a molecule-based transistor, consisting of two gold electrodes coated with polyvinylferrocene, (FeCp₂ ⁺/^{o})ₙ, and polyviologen, (PQ⁺/⁺)ₙ, and functionalized with a quinone-based polymer, (Q/QH₂)ₙ, having a pH-dependent redox potential which is more negative or positive than the potential of the viologen polymer, depending on the pH.

Fig. 1 is a schematic of the effect of pH variation on the polymers in the transistor of Fig. 1 and shows the approximate relationship of the redox potentials.

### Detailed Description of preferred embodiments of the Invention

The present invention provides molecule-based microelectrochemical devices consisting of one or more electrodes which can be individually contacted and independently functionalized using electroactive polymers with specific properties that are responsive to chemical and/or electrical signals. Examples of one group of electroactive polymers are redox polymers which are insulating when reduced and conducting when oxidized.

Typical microelectrodes are small, on the order of 2 to 5 microns wide by 50 to 150 microns long 0.1 to 0.15 microns thick, although even smaller electrodes may be utilized, and made of inert, electrically conductive material such as goldn silver, palladium, gold-platinum, and gold-palladium or other metals that are electrochemically inert. Larger electrodes are used in some of the devices such as the high energy density capacitors. The conductor should be easily deposited onto an inert substrate and have low electrical resistance, good adhesion to the substrate, stability, and ability to be functionalized.

A preferred substrate for the microelectrochemical devices is an oxidized silicon wafer made by growing a 4.5-10.0 x 10⁻⁷ m (4500 Angstroms to 10,000 Ångstroms) thick SiO₂ layer on <100> Si. Devices made according to the present invention on silicon wafers may be easily integrated into presently available solid state microelectronic devices, most of which are also produced on silicon wafers.

Various groups of polymers known to those skilled in the art are suitable for use in the present invention. Preferred such polymers can be electrochemically deposited on individual electrodes and can respond to a signal, in a reversible manner, in a way which can be electrochemically detected. Such materials are described by R.W. Murray in Electroanalytical Chemistry, Vol. 13, Edited by A.J. Bard (Marcel Dekker, N.Y., 1984).

Suitable electrochemically polymerizable materials for use in the present invention include redox polymers. Examples of such polymers are polypyrrole, polyaniline, poly-N-methylpyrrole, polythiophene, poly-3-methylthiophene and polymers of other thiophene derivatives, and polyvinylferrocene (poly vinyl dicyclopentadienyliron). Styrene and vinyl aromatic derivatives, such as vinyl pyrridine, vinyl, 2,2'-bipyridine and metal complexes of these derivatives, are also useful since they can be electrochemically polymerized and may be derivatized with a number of reagents, including biologically active agents such as enzymes and ionophores that complex with ions such as lithium and calcium.

Other polymers which are useful in the present invention include redox polymers known to be electrochromic materials, compounds which change color as a result of electrochemical reactions. Examples of such materials are polyvinylferrocene, polynitrostyrene, viologens, and polymers of thiophene or thiophene derivatives. Viologens, described by Wrighton et al in U.S. Patent Nos. 4,473,695 and 4,439,302, the teachings of which are incorporated herein, are compounds formed from 4,4'-bipyridinium which may be polymerized and covalently bonded or otherwise confined to the surfaces of electrodes. Viologens such as dialkyl-4,4'-bipyridinium di-cation and associated anions, dichloride, dibromide, or di-iodide, form contrasting colors when oxidized or reduced. Since each monomer unit of viologen has a 2+ charge which is balanced in the presence of two halide counter ions, the counter ions can be replaced with a complex ion such as PtCl₆ ²⁻ which can then be reduced to yield embedded elemental Pt(O) in highly dispersed form. An enzyme such as hydrogenase can also be immobilized onto or throughout the redox polymer to equilibrate the redox polymer with the enzyme substrates. Substituted viologens are useful for photogeneration of hydrogen from aqueous electrolytes, for reduction of metal-containing macromolecules, and on p-type silicon photocathodes in electrolytic cells.

The invention is further illustrated by the following non-limiting examples. Polypyrrole, poly-N-methylpyrrole, poly-3-methylthiophene, and polyaniline-based devices were constructed according to the procedure outlined below, with minor variations.

### Fabrication of Microelectrode Arrays

Microelectrode arrays were fabricated in the Massachussetts Institute of Technology Microelectronics Laboratory in the Center for Materials Science and Engineering which includes a class 100 clean room and is equipped to meet the specialized requirements for the production of solid state microelectronic devices such as "silicon chips".

A two-mask process was designed. The first mask was made for a metal lift-off procedure to form microelectrodes, leads, and contact pads. The second mask was made to pattern a photoresist overlayer leaving a 50 to 140 micron length of the microelectrodes and the contact pads exposed.

A microelectrode array was designed using the Computer Aided Design Program HPEDIT at a Hewlett Packard Model 2648A graphics terminal on a DEC-20. The design file was translated into Caltech Intermediate Form (CIF). This CIF file was translated to Mann compatible code and written on magnetic tape. Masks for photolithography were made from the file on magnetic tape using a Gyrex Model 1005A Pattern Generator. E-K 5" x 5" x 0.090" (127x127x2.29 mm) Extra Flat high reslution glass emulsion plates were used to make the photolithography masks. The emulsion plates were developed by a dark field process.

p-Si wafers of <100> orientation, 50.8 mm (two inches) in diameter and 0.28 mm (0.011 inches) thick, obtained from Wacker Corp. were used as substrates upon which to fabricate the microelectrode arrays. The silicon wafers were RCA cleaned in a laminar air flow hood in the class 100 clean room. The wafers were immersed in hot aqueous 6% by volume H₂O₂/14% by volume aqueous NH₃, briefly etched in hydrofluoric acid diluted 10:1 with deionized water, immersed in hot aqueous 6% by volume H₂O₂/14% by volume HCl, rinsed in deionized water (resistance greater than 14 Mohm·cm), and spun dry. The cleaned wafers were loaded immediately into an oxidation tube furnace at 1100°C under N₂. A dry/wet/dry/anneal oxidation cylce was used to grow a thermal oxide layer 4.5 x 10⁻⁷ m (4500 Ångstroms) thick. For the polyaniline-based triode, a dry oxidation cycle was used to grow a thermal oxide layer 1.185 x 10⁻⁶ m (11850 Ångstroms) thick. Oxide thicknesses were measured using a Gaertner Model L117 ellipsometer. The oxidized wafers were taken immediately to the photolitography stage.

Each oxidized wafer was flood-coated with hexamethyldisilazane and spun at 6000 rpm for 20 sec. One ml of MacDermid Ultramac PR-914 positive photoresist was syringed onto each wafer. The wafer coated with resist was spun for 30 sec at 4000 rpm and then prebaked 35 min at 90°C. For the polyaniline-based triode, one ml of Shipley 1470 positive photoresist was syringed onto each wafer and the wafer spun for 30 seconds at 6000 rpm. The coated wafer was then prebaked 25 minutes at 90°C.

A GCA Mann 4800 DSW Wafer Stepper was used to expose the photoresist. The Mann uses the 405 nm line of a 350 W Hg are lamp as a light source. The mask image is reduced 5:1 in the projection printing. An exposure time of 0.850 sec was used and the photoresist developed 60 sec in MacDermid Ultramac MF-62 diluted 1:1 with deionized water. For the polyaniline-based triode, the wafer was exposed for 1.2 seconds and developed 60 seconds in Shipley 312 developer diluted 1:1 with dionized water. The developed wafers were then cleaned in a planar oxygen etching chamber at 75-100 W forward power in 2.67 Nm⁻ (20 mtorr) of oxygen for 15 seconds.

A bilayer metallization was performed. A MRC 8620 Sputtering System was used in preparing the microelectrode arrays. The bilayer metallization of the wafers used in the polyaniline-based triode was performed in a NRC 3117 electron beam evaporation system. Wafers were placed on a quartz plate that was freshly coated with chronium. The wafers were backsputtered 2 min at 50 W forward power in an argon plasma at 0.67 Nm⁻ (5 mtorr). Chronium was sputtered at 50 W forward power to produce a layer of chronium. The layer on the wafers was 2 x 10⁻⁸ m (200 Ångstroms) thick. The layer in the polyaniline-based triode was 5 x 10⁻⁹ m (50 Ångstroms) thick. Gold was then sputtered at 50 W forward power to produce a layer 1 x 10⁻⁷ m (1000 Ångstroms) thick. Chronium serves as an adhesion layer for the gold. The combined chronium/gold thickness of the wafers used in the polyaniline-based device was measured to be 1.052 x 10⁻⁷ m (1052 Ångstroms) on a Dektak II surface profile measuring device.

At this point, the chronium/gold was in direct contact with the SiO₂ substrate only in the areas that were to form the microelectrodes, leads, and contact pads and on photoresist in all other areas. The chronium/gold on photoresist was removed by a lift-off procedure: the metallized wafers were immersed in warm acetone, in which soft-baked positive photoresist is soluble, for 75 minutes, except for the wafers used in the polyaniline-based triode which was for 5 minutes. The wafers used were briefly sonicated in acetone to remove the metal between microelectrodes, dried, and then cleaned of residual photoresist in a planar oxygen plasma etching chamber at 200 W forward power in 6.7 Nm⁻ (50 mtorr) oxygen for 60 sec.

The wafers used in the polyaniline-based triode were blasted with acetone from a Paasche air brush with N₂ at 70 psi, sonicated for 30 minutes in acetone, then rinsed with acetone and methanol before drying. The wafers then cleaned in a mixture of hot aqueous 6% by volume H₂O₂/14% by volume aqueous NH₃, rinsed in deionized water (greater than 14 megaohm·cm), and spun dry. The wafers were then baked at 180°C for 40 minutes before repeating the photoresist spin coating process. The wafers were again prebaked at 90°C for 25 minutes and then exposed in a Karl Suss America Inc. Model 505 aligner for 11 seconds, using a dark field mask. The photoresist was developed in Shipley 312 developer diluted 1:1 with deionized water to expose the bond pads and the array of microelectrode wires. The exposed areas were cleaned of residual photoresist in the oxygen plasma etching chamber at 75-100 W for 1 minute. The remaining photoresist was hardbaked at 180°C for 15 hours.

Wafers were then baked at 180°C for 40 minutes before repeating the photoresist spin coating process. The wafers were again prebaked at 90°C for 25 minutes and then exposed in a Karl Suss America Inc. Model 505 aligner for 11 seconds, using a dark field mask. The photoresist was developed in Shipley 312 developer diluted 1:1 with deionized water to expose the bond pads and the array of microelectrode wires. The exposed areas were cleaned of residual photoresist in the oxygen plasma etching chamber at 75-100 W for 1 minute. The remaining photoresist was hard baked at 180°C for 15 hours.

Individual die (chips) were scribed and separated. The chips were mounted on TO-5 headers from Texas Instruments with Epoxi-Patch 0151 Clear from Hysol Corp. A Mech-El Ind. Model NU-827 Au ball ultrasonic wire bonder was used to make wire bonds from the chip to the TO-5 header. The leads, bonding pads, wire bonds, and header were encapsulated with Epoxi-Patch 0151. The header was connected through a TO-5 socket to external wires. The external wires were encased in a glass tube. The header was sealed at the distal end of the glass tube with heat shrink tubing and Epoxi-Patch 1C white epoxy from Hysol Corp.

Prior to use as a microelectrode array, the array was tested to establish the leakage current between the various electrodes of the array. Arrays characterized as usable have a measured resistance between any two electrodes of greater than 10⁹ ohms in non-aqueous electrolyte solution containing no added electroactive species. Prior to use in experimentation the microelectrode arrays were tested further in aqueous electrolyte solution containing 0.01 M K₃[Fe(CN)₆] and 0.01 M K₄[Fe(CN)₆] or with [Ru(NH₃)₆]Cl₃ to establish that the microelectrodes give the expected response. Typically, a negative potential excursion to evolve H₂ cleaned the gold surface sufficiently to give good electrochemical response to the Fe(CN)₆ ^{3-/4-} or Ru(NH₃)₆ ^{3+/2+} redox couples. The electrolyte used for electrical measurement was 0.1 M NaClO₄ in H₂O solvent, 0.5 M NaHSO₄, or 0.1 M [n-Bu₄N]ClO₄ in CH₃CN solvent.

### Electrochemical Equipment

Most of the electrochemical experimentation was carried out using a Pine Model RDE 3 bipotentiostat and potential programmer. In cases where two microelectrodes were under active potential control and a third was to be probed, a PAR Model 363 potentiostat/galvanostat was used in conjunction with the Pine Model RDE 3. All potentials were controlled relative to an aqueous saturated calomel reference electrode (SCE). Typically, electrochemical measurements were carried out under N₂ or Ar at 25°C.

For the polyaniline-based triode, most of the electrochemical experimentation was carried out using a Pine model RDE 4 bipotentiostat and potential programmer. In some cases where only a single potentiostat was needed a PAR Model 173 potentiostat/galvanostat and a PAR Model 175 universal programmer was used. Potential step experiments were carried out using the RDE 4 with a Tektronix type 564B storage oscilloscope as the recorder.

### Derivatization of Microelectrodes

For the polypyrrole or poly-N-methylpyrrole-based devices, the gold microelectrodes were functionalized by oxidation of 25-50 mM pyrrole or N-methylpyrrole in CH₃CN/0.1 M [n-Bu₄N]ClO₄. The polypyrrole was deposited at +0.8 V vs. SCE, and the poly-N-methylpyrrole was deposited at +1.2 vs. SCE. The deposition of the polymer can be effected in a controlled manner by removing the array from the derivatization solution after passing a certain amount of charge. Electrodes were then examined by cyclic voltammetry in CH₃CN/0.1 M [n-Bu₄N]ClO₄ to assess the coverage of polymer and to determine whether the polymer coated two or more electrodes resulting in a "connection" between them.

Prior to use as a microlectrode array, each microelectrode wire in the devices used in the polyaniline-based triode was tested with an ohmmeter to make sure it was not shorted to any other wire on the device. Then each microelectrode was tested by running a cyclic voltammogram in 0.01 M Ru(NH₃)₆ ³⁺/0.1M NaNO₃/H₂O. The microelectrodes were derivatized by oxidation of a stirred 0.44 M aniline solution in 0.5 M NaHSO₄/H₂O at pH 1. The polyaniline was deposited at +0.9 V vs. SCE. Electrodes were then examined by cyclic voltammetry in 0.5 M NaHSO₄ at pH 1 to assess the coverage of polymer and to determine whether the polymer coated two or more electrodes resulting in a connection between them. Macroscopic gold electrodes were derivatized with polyaniline by the same procedure to accurately relate the thickness of polyaniline to cyclic voltammetry response and the charge passed in the anodic deposition. Typically, a portion of the gold flag was covered with grease prior to depositing the polyaniline over the exposed gold surface. The grease was then removed with CH₂Cl₂ to give a well defined step from gold to polyaniline.

Poly-3-methylthiophene was grown onto microelectrode surfaces approximately 50 microns long, 1-2 microns wide, 0.1 microns high and separated by approximately 1 micron (10,000 Angstroms) by oxidizing 3-methylthiophene in CH₃CN/0.1 M [n-Bu₄N]ClO₄ solution. The typical procedure involves cycling at 200 mV/S the potential of an electrode to be derivatized between 0.0 V and +1.8 Vvs. SCE in the presence of 50 mM 3-methylthiophene. The deposited polymer exhibits a cyclic voltammetry wave with a peak at bout +0.7 V vs. SCE, which can be used to gauge the amount of deposited polymer. In derivatizing a microelectrode array, only those electrodes to be derivatized are cycled and those not to be derivatized are held at a negative potential, -1.0 V vs. SCE, to preclude growth of the poly-3-methylthiophene.

### Polymer-based Transistors

A pair of polymer-connected microelectrodes functions as a transistor where a transistor is defined as a material whose resistance can be adjusted by a chemical or electrical signal. Current between the two microelectrodes at a given potential difference, V_{D}, is varied as a function of the gate potential, V_{G}, of the polymer electrically connecting the electrodes. One of the electrodes is regarded as the "source" and the other as the "drain", with the source being referenced to the solution as a "gate" when the device is used to amplify an electrical signal.

Closely spacing the electrodes, typically on the order of 0.1 to 2 microns, combined with the use of electroactive polymers with specific properties is crucial to the functioning of the transistor-like device. The smallest inter-electrode space technically feasible is preferred. The small inter-electrode space allows high current densities. As the distance between microelectrodes is increased, output decreases and "noise" increases. The direction of current flow, the ability to respond to a chemical signal such as a change in pH, the rate of response, the degree of response, the storage of energy, and the ability to place other pairs of electrodes in close proximity without interference is due to the choice, deposition, degree of separation and quantity of polymer.

For polypyrrole and poly-N-methylpyrrole, the oxidized materials are electronic conductors whose conductivity varies by more than 10¹⁰ depending on the redox state of the polymers. The consequence of the very large difference in conductivity with redox state is that the potential drop can occur across a very small fraction of length of the connecting polymer when one microelectrode is held at a potential where the polymer is reduced and insulating and the other is held at a potential where the polymer is oxidized and conducting. For example, polypyrrole is insulating at approximately -0.4 V vs. SCE potential but becomes conducting at positive potentials up to any positive potential at which the polypyrrole is durable. The actual conductivities of the oxidized polymers, measured in CH₃CH/0.1 M [n-Bu₄N]ClO₄, of polypyrrole and poly-N-methylpyrrole, respectively, are approximately 10⁻ ohm⁻¹ · cm⁻¹ and 10⁻⁴ to 10⁻⁵ ohm⁻¹ ·cm⁻¹.

The potential at which a polymer exhibits a sharp change in conductivity due to oxidation is the threshold potential, V_{T}. V_{T} can be manipulated by using different monomers or different redox polymers, and by varying the medium to be "seen" by the polymer.

In a polymer-based device such as a poly-3-methylthiophene-based device, the polymer is the analogue of the channel of a solid state field effect transistor since the conductivity of the polymer changes by greater than 10⁸, depending on the potential. Electrical signals can be amplified by a factor of about 1000 by poly-3-methylthiophene-based transistors at frequencies of 10 Hz. For electrical signals, when the gate voltage is negative, the "channel" is closed and there is a resistance of greater than 10¹⁰ ohms between microelectrodes. When the gate voltage is positive, the "channel" is open and the resistance between microelectrodes is approximately 10 ohms. For chemical signals, a reductant acts to close the "channel" (resistance of the polymer is again greater than 10¹⁰ ohms) and an oxidant opens the "channel" (resistance of the polymer is approximately 10 ohms).

### Multiple-polymer-based Sensors

As shown in Fig. 1a, a molecule-based pH sensor 40 can be fabricated using a two microelectrode array on a SiO₂-Si substrate 42.

The two gold microelectrodes 44, 45 are coated with polyviologen 46, (PQ^{2+/+})ₙ, and polyvinylferrocene 48, (FeCp₂ ^{+/o})ₙ, respectively, and then overlaid with another polymer 50 with a different pH dependent redox potential, such as a polyquinone, (Q/QH₂)ₙ, whose redox potential is above the redox potential of the polyviologen at high pH and between that of the polyviologen and polyvinylferrocene at low pH.

The pH variation serves as the signal to be amplified. Varying the pH results in a variation in current passing between the two gold electrodes at a fixes potential difference with the negative lead to the viologen coated electrode. As shown by Fig. 1b, alteration of the pH changes the redox potential of polymer 50. Low pH acts to make it easier to reduce polymer 50. Current can flow between source 44 and drain 45 when the negative lead is attached to the polyviologen-coated gold microelectrode 44 and the positive lead is connected to the polyvinylferrocene-coated gold microelectrode 45 and the redox potential of the polyquinone is between the redox potentials of the two polymers 46 and 50 coating source 44 and drain 45. At a fixed potential difference, the current passing between the two microelectrodes 44 and 45 should depend on the pH of the solution contacting the polymer 50.

"DEC" is a Registered Trademark. "MacDermid Utramac PR-914" and "Epoxi-Patch O1S1" are trademarks.

## Claims

1. A microelectronic pH sensor device (40) comprising a first (44) and a second (45) electrically conductive electrode on an insulating substrate each overlaid respectively with a first (46) and a second (48) electroactive polymer which completely covers those portions of the respective electrodes which do not abut the substrate, the first and second electroactive polymers being separate from one another but connected together by a third electroactive polymer (50), wherein the redox potential of the third electroactive polymer (50) is selected to be higher than that of the first electroactive polymer (46) when in contact with a solution of high pH, and between that of the first electroactive polymer (46) and the second electroactive polymer (48) when in contact with a solution of low pH.

2. A pH sensor device according to claim 1 wherein the first electroactive polymer is polyviologen, the second electroactive polymer is polyvinylferrocene and the third electroactive polymer is polyquinone.

3. The device of any preceding claim wherein said electrodes are formed of conductive electrochemically inert metals selected from the group consisting of gold, silver, palladium, and gold-platinum.

4. The device of any preceding claim wherein said polymer is polymerized from electrochemically polymerizable monomers or photopolymerizable monomers.

5. The device of any preceding claim wherein said polymer further comprises a material selected from the group consisting of metals, ionophores, enzymes, and other catalysts.

6. The device of claim 5 wherein the polymer comprises a catalyst which is a noble metal or an enzyme.

## Patentansprüche

1. Mikroelektronischer pH-Fühler (40), umfassend eine erste (44) und eine zweite (45) elektrisch leitende Elektrode auf einem isolierenden Substrat, von denen jede mit einem ersten (46) und einem zweiten (48) elektrisch aktiven Polymer, das die nicht am Substrat anliegenden Teile der betreffenden Elektroden vollständig bedeckt, überlagert ist, wobei die ersten und zweiten elektrisch aktiven Polymeren (zwar) von einander getrennt, aber durch ein drittes elektrisch aktives Polymer (50) verbunden sind und wobei das Redoxpotential des dritten elektrisch aktiven Polymers (50) dergestalt gewählt wird, daß es bei Kontakt mit einer Lösung hohen pH-Werts höher ist als dasjenige des ersten elektrisch aktiven Polymers (46) und bei Kontakt mit einer Lösung niedrigen pH-Werts zwischen denjenigen des ersten elektrisch aktiven Polymers (46) und des zweiten elektrisch aktiven Polymers (48) liegt.

2. pH-Fühler nach Anspruch 1, wobei das erste elektrisch aktive Polymer aus Polyviologen, das zweite elektrisch aktive Polymer aus Polyvinylferrocen und das dritte elektrisch aktive Polymer aus Polychinon bestehen.

3. Vorrichtung nach einem der vorhergehenden Ansprüche, wobei die Elektroden aus leitenden, elektrochemisch inerten Metallen, ausgewählt aus der Gruppe Gold, Silber, Palladium und Gold-Platin, gebildet sind.

4. Vorrichtung nach einem der vorhergehenden Ansprüche, wobei das Polymer aus elektrochemisch polymerisierbaren Monomeren oder photopolymerisierbaren Monomeren polymerisiert ist.

5. Vorrichtung nach einem der vorhergehenden Ansprüche, wobei das Polymer weiterhin ein Material, ausgewählt aus der Gruppe Metalle, Ionophore, Enzyme und sonstige Katalysatoren, umfaßt.

6. Vorrichtung nach Anspruch 5, wobei das Polymer einen aus einem Edelmetall oder einem Enzym bestehenden Katalysator umfaßt.

## Revendications

1. Dispositif micro-électronique (40) capteur de pH comprenant des première (44) et deuxième (45) électrodes électriquement conductrices sur un substrat isolant, chacune recouverte respectivement par des premier (46) et deuxième (48) polymères électroactifs qui recouvrent complètement ces parties des électrodes respectives qui ne prennent pas appui sur le substrat, les premier et deuxième polymères électroactifs étant séparés l'un de l'autre, mais reliés ensemble par l'intermédiaire d'un troisième polymère électroactif (50), dans lequel le potentiel redox du troisième polymère électroactif (50) est choisi pour être plus élevé que celui du premier polymère électroactif (46) lorsqu'il est en contact avec une solution au pH élevé, et pour être compris entre celui du premier polymère électroactif (46) et du deuxième polymère électroactif (48) lorsqu'il est en contact avec une solution au pH bas.

2. Dispositif capteur de pH selon la revendication 1, dans lequel le premier polymère électroactif est le polyviologène, le deuxième polymère électroactif est le polyvinylferrocène et le troisième polymère électroactif est la polyquinone.

3. Dispositif selon l'une quelconque des revendications précédentes, dans lequel lesdites électrodes sont formées de métaux inertes électrochimiquement conducteurs choisis parmi le groupe se composant de l'or, de l'argent, du palladium et du platine-or.

4. Dispositif selon l'une quelconque des revendications précédentes, dans lequel ledit polymère est polymérisé à partir de monomères polymérisables électrochimiquement ou de monomères photopolymérisables.

5. Dispositif selon l'une quelconque des revendications précédentes, dans lequel ledit polymère comprend en outre un matériau choisi parmi le groupe se composant de métaux, d'ionophores, d'enzymes et autres catalyseurs.

6. Dispositif selon la revendication 5, dans lequel le polymère comprend un catalyseur qui est un métal noble ou une enzyme.
